# EUROPÄISCHE PATENTSCHRIFT

(11) **EP 2 932 804 B1**
(45) Veröffentlichungstag und Bekanntmachung des Hinweises auf die Patenterteilung: **06.04.2022**
(21) Anmeldenummer: 13794867.5
(22) Anmeldetag: 18.11.2013
(51) Int. Cl.: H05K 1/05, H05K 7/14, H05K 7/20, H05K 3/00, H05K 1/02

(54) **ELEKTRISCHE BAUGRUPPE ZUR MONTAGE AUF EINER HUTSCHIENE**
ELECTRIC ASSEMBLY TO BE MOUNTED ON A TOP-HAT RAIL
BLOC ÉLECTRIQUE DESTINÉ À ÊTRE MONTÉ SUR UN PROFILÉ CHAPEAU

(30) Priorität: 17.12.2012 DE 102012112389
(43) Veröffentlichungstag der Anmeldung: 21.10.2015
(73) Patentinhaber: Phoenix Contact GmbH & Co. KG, 32825 Blomberg (DE); Phoenix Contact Power Supplies GmbH, 33106 Paderborn (DE)
(72) Erfinder: HENKEL, Hartmut, 32825 Blomberg (DE); HEINEMANN, Michael, 32791 Lage (DE); REMMERT, Guido, 59063 Hamm (DE)
(74) Vertreter: Patentship Patentanwaltsgesellschaft mbH
(86) Internationale Anmeldenummer: PCT/EP2013/074087
(87) Internationale Veröffentlichungsnummer: WO 2014/095199

(56) Entgegenhaltungen:
- EP-A2- 1 538 670
- WO-A1-02/39799
- WO-A1-2012/160059
- DE-A1- 19 859 739
- DE-A1- 19 939 933
- DE-C1- 19 748 530
- US-A1- 2003 206 399
- US-A1- 2007 206 361

## Beschreibung

Die vorliegende Erfindung betrifft eine elektrische Baugruppe zur Montage auf einer Hutschiene.

Elektrische Bauteile in elektrische Baugruppen und Funktionsbaugruppen, wie z.B. Stromversorgungseinheiten, werden auf gedruckten Leiterkarten oder sogenannten Printed Circuit Boards (PCB) aufgebaut. An ihnen sind die einzelnen Bauteile der elektrischen Baugruppe und Funktionsbaugruppe mechanisch befestigt und elektrisch leitend miteinander verbunden. Die gedruckten Leiterkarten oder PCB weisen Phenolharz und Papier, Epoxidharz und Papier oder Epoxidharz und Glasfasergewebe als Trägermaterial auf, auf dem elektrische Leiterbahnen, z.B. in Form einer Kupferbeschichtung mit einer Schichtdicke von einigen µm, aufgebracht sind. Das Trägermaterial ist elektrisch isolierend, weist aber eine begrenzte thermische Leitfähigkeit auf. Daher muss die von den elektrischen Bauteilen erzeugte Wärmeenergie durch zusätzliche Kühlkörper an die Umgebung abgeführt werden. Diese zusätzlichen Kühlkörper erfordern einen zusätzlichen Montageschritt und nehmen Bauraum in Anspruch.

Die Druckschrift DE 198 59 739 A1 betrifft eine Kühlvorrichtung zur Verwendung in einem elektronischen Steuergerät umfassend einen Baugruppenträger mit einer Oberseite und einer Unterseite und einem auf die Unterseite aufgebrachten Kühlkörper.

Die Druckschrift EP 1 538 670 A2 betrifft ein Halbleitermodul, das ein Halbleiterbauteil, einen elektrischen Leiter und ein Substrat umfasst. Hierbei besteht das Substrat aus einer Metallplatte, Leiterbahnen und einer Isolationsschicht, die zwischen der Metallplatte und den Leiterbahnen eingefügt ist.

Die Druckschrift US 2003/0206399 A1 betrifft ein elektrisches System mit elektrischen Einheiten und einem Kühlkörper, welcher von den elektrischen Einheiten freigesetzte Wärme ableitet.

Die Druckschrift WO 02/39799 A1 betrifft eine Kontrollschaltung für Elektromotoren, die in einem Gehäuse mit Deckel eingebaut ist. Hierbei besteht der Deckel aus einer Aluminiummetallplatte, die Teil des Gehäuses ist und auf deren Innenseite Leitungsbahnen angebracht sind.

Die Druckschrift DE 199 39 933 A1 betrifft eine Leistungs-Moduleinheit, die aus Halbleiterbauteilen besteht, welche auf einer Leiterplatte angebracht sind.

Die Druckschrift DE 197 48 530 C1 betrifft ein modulares Automatisierungsgerät mit anreihbaren, auf einer Tragschiene gehaltenen Basismodulen mit Außenkontakten.

Es ist daher die Aufgabe der vorliegenden Erfindung eine elektrische Baugruppe bereitzustellen, die einfacher zu Montieren und weniger Bauraum in Anspruch nimmt.

Diese Aufgabe wird durch den Gegenstand mit den Merkmalen nach dem unabhängigen Anspruch gelöst. Vorteilhafte Ausführungsformen sind Gegenstand der abhängigen Ansprüche, der Beschreibung und der Zeichnungen.

Die vorliegende Erfindung basiert auf der Erkenntnis, dass eine elektrisch isolierte Metallplatte aufgrund ihrer Wärmeleitfähigkeit einen Verzicht auf zusätzliche Kühlkörper erlaubt.

Gemäß einem ersten Aspekt wird die Aufgabe durch eine elektrische Baugruppe zur Montage auf einer Hutschiene gelöst, mit:
- einer elektrischen Stromversorgungskomponente;
- einem mehrschichtigen Träger, umfassend eine Metallplatte, eine Leiterbahnschicht zur elektrischen Kontaktierung der elektrischen Stromversorgungskomponente und eine elektrische Isolationsschicht, welche zwischen der Metallplatte und der Leiterbahnschicht angeordnet ist; wobei
- die elektrische Stromversorgungskomponente mit der Metallplatte wärmeleitend verbunden ist, um Wärmeenergie von der elektrischen Stromversorgungskomponente abzuführen.

Dadurch wird der technische Vorteil erreicht, dass durch die gute Wärmeleitfähigkeit der Metallplatte die von der Stromversorgungskomponente, wie. z.B. elektrische Bauteile eines Schaltnetzteils, erzeugte Wärmeenergie gut abgeführt wird, so dass auf zusätzliche Kühlkörper verzichtet werden kann. Somit ist keine Montage von zusätzlichen Kühlkörpern mehr nötig und der Bauraumbedarf für die elektrische Baugruppe ist reduziert.

In einer vorteilhaften Ausführungsform ist die Metallplatte oder die Leiterbahnschicht aus zumindest einem der folgenden Materialien gebildet ist: Aluminium, Kupfer, Aluminium enthaltende Legierung, Kupfer enthaltende Legierung. Dadurch wird der technische Vorteil erreicht, dass die Metallplatte aus leicht zu verarbeitenden Materialien mit guter thermischer Leitfähigkeit gefertigt wird. Dies verbessert die Kühlwirkung der Metallplatte und erlaubt zugleich, sie einfach zu fertigen.

In einer vorteilhaften Ausführungsform ist die Leiterbahnschicht durch elektrische Leiterbahnen gebildet. Dadurch wird der technische Vorteil erreicht, dass die Stromversorgungskomponente, z.B. elektrische Bauteile eines Schaltnetzteils, der elektrischen Baugruppe auf einfache Art und Weise elektrisch leitend miteinander verbunden sind.

Erfindungsgemäß ist die elektrische Isolationsschicht eine thermisch leitende Dielektrikumsschicht. Dadurch wird der technische Vorteil erreicht, dass durch die thermisch leitende Dielektrikumsschicht von der Stromversorgungskomponente, z.B. elektrische Bauteile eines Schaltnetzteils, erzeugte Wärmeenergie zu der Metallplatte abgeführt werden kann. Dies steigert die Kühlwirkung nochmals.

In einer vorteilhaften Ausführungsform ist die Metallplatte als Schirm für ein von der elektrischen Stromversorgungskomponente abstrahlbares elektromagnetisches Wechselfeld vorgesehen. Dadurch wird der technische Vorteil erreicht, dass die Metallplatte neben der Kühlfunktion eine weitere, zusätzliche Funktion aufweist. Sie dient neben der Kühlung auch der Abschirmung von elektromagnetischen Wechselfeldern, die von der Stromversorgungskomponente der elektrischen Baugruppe emittiert werden. Somit kann die elektrische Baugruppe auch in einem EMV-sensitiven Umfeld eingesetzt werden.

In einer vorteilhaften Ausführungsform ist die Metallplatte zur Abschirmung elektromagnetischer Wechselfelder mit einer Frequenz von bis zu 30 MHz ausgebildet. Dadurch wird der technische Vorteil erreicht, dass besonders die Frequenzen elektromagnetischer Wechselfelder abgeschirmt werden, die bei Betrieb von der Stromversorgungskomponente, der elektrischen Baugruppe auftreten, insbesondere wenn die elektrische Baugruppe als Schaltnetzteil ausgebildet ist.

In einer vorteilhaften Ausführungsform ist die Metallplatte vollflächig ausgebildet ist. Dadurch wird der technische Vorteil erreicht, dass die Abschirmung elektromagnetischer Wechselfelder nochmals verbessert wird.

In einer vorteilhaften Ausführungsform ist die Metallplatte mit einem Referenzpotential, insbesondere mit einem Massepotential, verbindbar. Dadurch wird der technische Vorteil erreicht, dass die durch die elektromagnetischen Wechselfelder induzierten elektrischen Spannungen abgeleitet werden können, was die Abschirmung elektromagnetischer Wechselfelder weiter verbessert.

In einer vorteilhaften Ausführungsform ist die elektrische Stromversorgungskomponente ein Schaltnetzteil. Dadurch wird der technische Vorteil erreicht, dass eine besonders einfach zu fertigende elektrische Baugruppe in Form eines Schaltnetzteils mit geringem Bauraumbedarf bereitgestellt wird, die ferner aufgrund der Abschirmwirkung der Metallplatte gegenüber elektromagnetischen Wellenfeldern sich für den Einsatz in EMV-sensitiven Umgebungen eignet.

Erfindungsgemäß umfasst die elektrische Baugruppe ferner ein Gehäuse, das vorgesehen ist, den mehrschichtigen Träger und die elektrische Stromversorgungskomponente zu hausen, wobei ein Gehäuseabschnitt des Gehäuses mit der Metallplatte wärmeleitend verbunden ist. Dadurch wird der technische Vorteil erreicht, dass die elektrische Baugruppe geschützt, z.B. gegen Feuchtigkeit und Staub, in einem Gehäuse untergebracht ist und zugleich durch die wärmeleitende Verbindung der Metallplatte mit dem Gehäuseabschnitt Wärmeenergie, die von der Stromversorgungskomponente, z.B. elektrischen Bauteilen eines Schaltnetzteil, erzeugt wird, aus dem Gehäuse in die Umgebung abgeführt wird, so dass es zu keiner Überhitzung innerhalb des Gehäuses kommt.

In einer vorteilhaften Ausführungsform ist der mehrschichtige Träger ein Copper-Clad-Träger. Dadurch wird der technische Vorteil erreicht, dass die elektrische Baugruppe unter Verwendung von Copper-Clad Material leicht zu fertigen ist und zugleich durch den Kupferanteil des Copper-Clad Materials eine besonders gute Wärmeleitfähigkeit und damit Kühlwirkung aufweist.

Gemäß einem zweiten Aspekt wird die Aufgabe durch die Verwendung von Copper Clad Material als gedruckte Leiterkarte in einer elektrischen Baugruppe gelöst. Dadurch wird der technische Vorteil erreicht, dass durch die gute Wärmeleitfähigkeit von Copper Clad Material Wärmeenergie gut abgeführt wird, so dass auf zusätzliche Kühlkörper verzichtet werden kann. Somit ist keine Montage von zusätzlichen Kühlkörpern mehr nötig und der Bauraumbedarf für die elektrische Baugruppe ist reduziert.

Weitere Ausführungsbeispiele werden Bezug nehmend auf die beiliegenden Zeichnungen erläutert. Es zeigen:
- Fig. 1: eine perspektivische Ansicht einer elektrischen Baugruppe;
- Fig. 2: eine perspektivische Ansicht eines mehrschichtigen Trägers mit einer Stromversorgungskomponente;
- Fig. 3: eine weitere perspektivische Ansicht eines mehrschichtigen Trägers mit einer Stromversorgungskomponente; und
- Fig. 4: eine Schnittdarstellung eines Kühlkörpers;
- Fig. 5: eine Schnittdarstellung eines weiteren Kühlkörpers; und

- Fig. 6: eine Schnittdarstellung eines weiteren Kühlkörpers mit einer elektrischen Baugruppe.

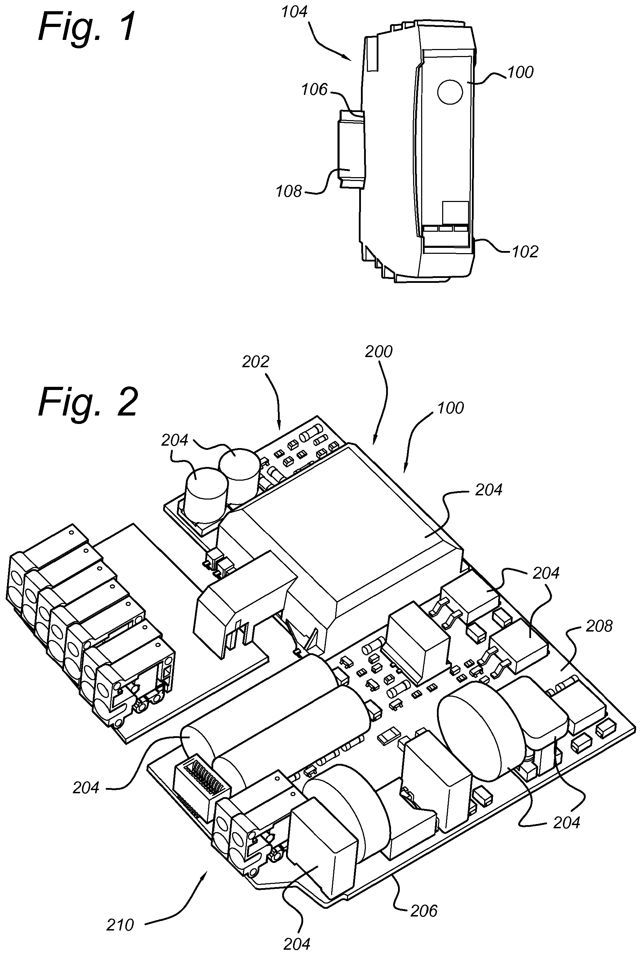

Fig. 1 zeigt ein Schaltnetzteil als Ausführungsbeispiel für eine elektrische Baugruppe 100. Die elektrische Baugruppe 100 weist ein Gehäuse 102 auf, das im vorliegenden Ausführungsbeispiel an seiner Rückseite 104 eine Rasteinrichtung 106 aufweist, mit der es auf einer Hutschiene 108 verrastet ist.

Fig. 2 zeigt ein Ausführungsbeispiel einer Stromversorgungskomponente 200 der elektrischen Baugruppe 100. Die Stromversorgungskomponente 200 ist im vorliegenden Ausführungsbeispiel als Schaltnetzteil 202 ausgebildet.

Die Stromversorgungskomponente 200 umfasst im vorliegenden Ausführungsbeispiel eine Mehrzahl von elektrischen Bauteilen 204, die auf einen im vorliegenden Ausführungsbeispiel mehrschichtigen Träger 206 angeordnet und entsprechend verschaltet sind. Der mehrschichtige Träger weist eine Oberseite 208 auf, auf der elektrische Bauteile 204 angeordnet sind, sowie eine der Oberseite 208 gegenüberliegende Unterseite auf, die wie später noch erläutert wird, als Gegenkontaktfläche 210 ausgebildet ist.

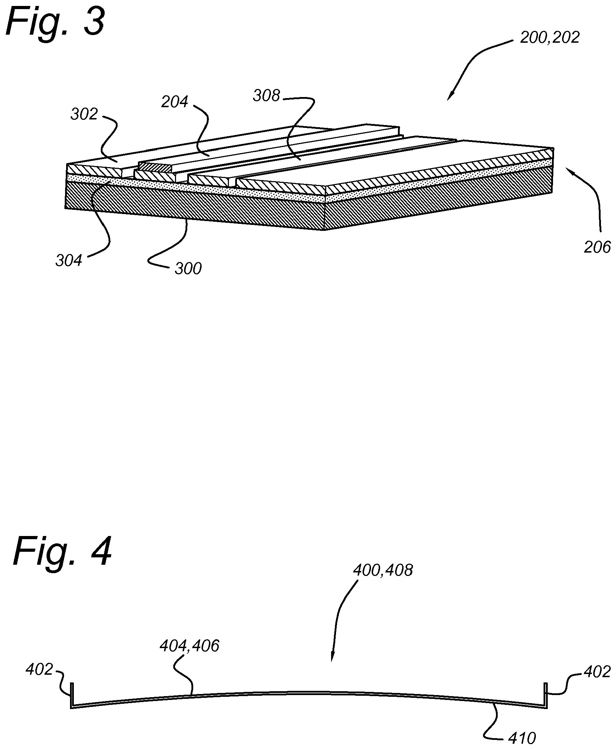

Fig. 3 zeigt ein Ausführungsbeispiel eines mehrschichtigen Trägers 206 für das Schaltnetzteil 202. Im vorliegenden Ausführungsbeispiel ist der mehrschichtige Träger 206 ein Copper-Clad-Träger.

Der mehrschichtige Träger 206 weist im vorliegenden Ausführungsbeispiel eine Metallplatte 300, eine Leiterbahnschicht 302 zur elektrischen Kontaktierung von elektrischen Bauteilen 204 der elektrischen Stromversorgungskomponente 200 bzw. des Schaltnetzteils 202 und eine elektrische Isolationsschicht 304 auf, welche zwischen der Metallplatte 300 und der Leiterbahnschicht 302 angeordnet ist.

Im vorliegenden Ausführungsbeispiel ist die Metallplatte 300 aus Aluminium oder Kupfer, oder aus einer Legierung gebildet, die Aluminium oder Kupfer enthält. Ferner schirmt im vorliegenden Ausführungsbeispiel die Metallplatte 300 elektromagnetische Wechselfelder ab, die bei Betrieb des Schaltnetzteils 202 von den elektrischen Bauteilen 204 abgestrahlt werden. Hierzu ist im vorliegenden Ausführungsbeispiel die Metallplatte 300 vollflächig ausgebildet, d.h. sie weist keine Bohrungen oder Durchbrüche auf, die sich durch ihre Dicke erstrecken. Um einen Einsatz des Schaltnetzteils 202 auch in einem EMV-sensitiven Umfeld zu ermöglichen ist die Metallplatte 300 zur Abschirmung elektromagnetischer Wechselfelder mit einer Frequenz von bis zu 30 MHz ausgebildet ist, da elektromagnetische Wechselfelder mit derartigen Frequenzen beim Betrieb des Schaltnetzteils 202 auftreten können.

Die Leiterbahnschicht 302 bildet Leiterbahnen 308, die der elektrischen Kontaktierung von elektrischen Bauteilen 204 dienen. Im vorliegenden Ausführungsbeispiel ist die Leiterbahnschicht 302 aus Aluminium oder Kupfer, oder aus einer Legierung gebildet, die Aluminium oder Kupfer enthält.

Die elektrische Isolationsschicht 304 ist im vorliegenden Ausführungsbeispiel eine thermisch leitende Dielektrikumsschicht. So wird eine gut wärmeleitende Verbindung zwischen den elektrischen Bauteilen 204 und der Metallplatte 300 gebildet, um Wärmeenergie von der elektrischen Stromversorgungskomponente 200 abzuführen.

Fig. 4 zeigt ein Ausführungsbeispiel für einen Kühlkörper 400 zur Kühlung der Stromversorgungskomponente 200. Der Kühlkörper 400 ist im vorliegenden Ausführungsbeispiel als Gehäuseabschnitt 410 eines Gehäuses 408 zur Hausung der Stromversorgungskomponente 200 ausgebildet, und kann mit einem weiteren Teilgehäuse (nicht dargestellt), das als Deckel ausgebildet ist, verschlossen werden.

Der Kühlkörper 400 ist im vorliegenden Ausführungsbeispiel einstückig und materialeinheitlich aus faserverstärktem Kunststoff gefertigt, wobei dem Kunststoffmaterial ferner im vorliegenden Ausführungsbeispiel Glasfasern, Keramiken, Oxide, keramische Oxide, Metalloxide hinzugefügt wurden, um die Wärmeleitfähigkeit weiter zu steigern und damit die Kühlwirkung des Kühlkörpers 400 zu optimieren.

Der Kühlkörper 400 weist im vorliegenden Ausführungsbeispiel zwei seitliche Begrenzungen 402 auf, die, wie noch später beschrieben wird, der Positionierung einer Stromversorgungskomponente 200 dienen. Ferner weist im vorliegenden Ausführungsbeispiel der Kühlkörper 400 eine Kontaktfläche 404 auf, die in wärmeleitendem Kontakt mit einer der Gegenkontaktfläche 210 des Trägers 206 der Stromversorgungskomponente 200 gebracht werden kann, um die Stromversorgungskomponente 200 zu entwärmen und dadurch zu kühlen.

Im vorliegenden Ausführungsbeispiel ist die Kontaktfläche 404 als elastisch verformbarer Abschnitt 406 des Kühlkörpers 400 ausgebildet. Der elastisch verformbare Abschnitt 406 ist im vorliegenden Ausführungsbeispiel händisch verformbar ausgebildet. Es ist somit eine Verformung ohne Werkzeug- oder Maschineneinsatz möglich. Im Ausgangszustand, wie in Fig. 4 dargestellt, ist die Kontaktfläche 404 konvex gekrümmt ausgebildet. Nach der Montage, also im montierten Zustand, ist die Kontaktfläche 404 im vorliegenden Ausführungsbeispiel im Vergleich zum Ausgangszustand in einem Flächenabschnitt durch elastische Verformung abgeflacht, wie noch später erläutert wird.

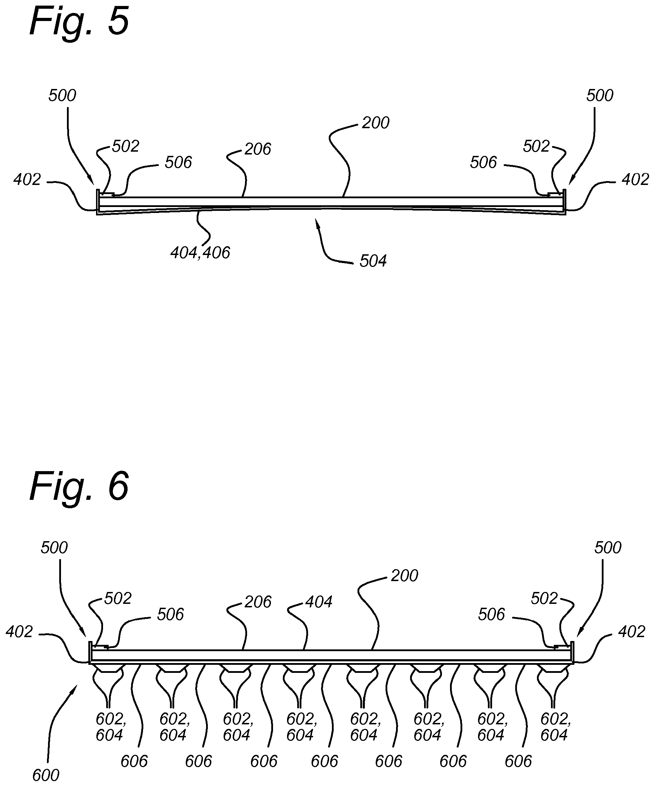

Fig. 5 zeigt ein weiteres Ausführungsbeispiel für einen Kühlkörper 400 zur Kühlung der Stromversorgungskomponente 200.

Der in Fig. 5 dargestellte Kühlkörper 400 weist den gleichen Aufbau wie der in Fig. 4 dargestellte Kühlkörper 400 auf, bis auf den Unterschied, dass der Kühlkörper 400 gemäß der Fig. 5 eine Aufnahme 500 für die Stromversorgungskomponente 200 aufweist.

Die Aufnahme 500 umfasst im vorliegenden Ausführungsbeispiel je eine an die beiden Begrenzungen 402 angeformte Halteschiene 502 auf, die im vorliegenden Ausführungsbeispiel die gleiche Erstreckungsrichtung wie die Begrenzungen 402 aufweisen. Die Halteschienen 502 sind im vorliegenden Ausführungsbeispiel wie die Begrenzungen 402 aus dem gleichen Material wie die Begrenzungen 402 gefertigt. Somit ist im vorliegenden Ausführungsbeispiel der Kühlkörper 400 mit den Begrenzungen 402 und den Halteschienen 502 einstückig und materialeinheitlich aus faserverstärktem Kunststoff gefertigt, dem im vorliegenden Ausführungsbeispiel Keramiken, Oxide, keramische Oxide, Metalloxide hinzugefügt wurden, um die Wärmeleitfähigkeit weiter zu steigern.

Die Fig. 5 zeigt ferner, dass der Kühlkörper 500 mit der Stromversorgungskomponente 200 verbunden wurde.

Die Kontaktfläche 404 steht mit einem Flächenabschnitt 504 in unmittelbarem Kontakt mit der Gegenkontaktfläche 210 des Trägers 206. So kann Wärmeenergie von elektrischen Bauteilen 204 durch den Träger 206 zu dem Kühlkörper 400 abgeführt werden. Zu erkennen ist ferner, dass der Kühlkörper 400 in geringerem Umfang konvex gekrümmt ist. So wird ein Flächenanteil 504 der Kontaktfläche 404, der mit der Gegenkontaktfläche 210 durch die Montage des Kühlkörpers 400 in Kontakt gebracht wird, vergrößert und so die wärmeleitfähige Verbindung zwischen dem Kühlkörper 400 und der Stromversorgungskomponente 200 verbessert. Dabei wird während der Montage der Kühlkörper 400 mit seiner Kontaktfläche 404 auf die Gegenkontaktfläche 210 gedrückt.

Die beiden Halteschienen 502 stehen im vorliegenden Ausführungsbeispiel in Kontakt mit Randabschnitten 506 des Trägers 206. Somit umgreifen die Halteschienen 502 den Träger 206 im vorliegenden Ausführungsbeispiel u-förmig. Durch diesen Kontakt der Randabschnitte 506 mit den Halteschienen 502 wird der elastische Abschnitt 406 so verformt, dass der elastisch verformbare Abschnitt 406 abgeflacht ist und in flächigem Kontakt mit der Gegenkontaktfläche 210 steht.

Fig. 6 zeigt ein weiteres Ausführungsbeispiel für einen Kühlkörper 400 zur Kühlung der Stromversorgungskomponente 200.

Der in Fig. 6 dargestellte Kühlkörper 200 weist den gleichen Aufbau wie der in Fig. 5 dargestellte Kühlkörper 400 auf, bis auf den Unterschied, dass die Kontaktfläche 404 vollflächig in Kontakt mit der Gegenkontaktfläche 210 des Trägers 206 steht, so dass der Wärmeübertrag von dem Träger 206 auf den Kühlkörper 400 maximiert ist.

Ferner weist der in Fig. 6 dargestellte Kühlkörper 400 eine als Wärmeabstrahlfläche 600 ausgebildete Rückseite auf. Hierzu weist die Wärmeabstrahlfläche 600 im vorliegenden Ausführungsbeispiel Erhebungen 602 auf, die die Oberfläche der Wärmeabstrahlfläche 600 vergrößern und so die Entwärmung von elektrischen Bauteile 204 verbessert wird. Dabei ist im vorliegenden Ausführungsbeispiel die Wärmeabstrahlfläche 600 ausgebildet, Wärmeenergie in Form von IR-Strahlung abzugeben.

Hierzu sind im vorliegenden Ausführungsbeispiel die Erhebungen 602 so ausgebildet, dass die abgegebene IR-Strahlung nicht wieder auf die Wärmeabstrahlfläche 600 trifft. Im vorliegenden Ausführungsbeispiel weisen die Erhebungen 602 hierzu Phasen 604 mit einem Winkel von 45° zur Ebene der Wärmeabstrahlfläche 600 bzw. der Kontaktfläche 404 auf, die zwischen Abschnitten 606 der Wärmeabstrahlfläche 600 angeordnet sind, deren Ebenen parallel zu der Ebene der Wärmeabstrahlfläche 600 bzw. der Kontaktfläche 404 sind. Dabei sind im vorliegenden Ausführungsbeispiel die Abschnitte 606 auf unterschiedlichen Höhenniveaus angeordnet.

Zur Montage wird der Kühlkörper 400 soweit verformt, dass der verformbare Abschnitt 406 der Kontaktfläche 404 einen so geringen Grad an Konvexität aufweist, dass der Träger 206 mit seinen Randabschnitten 506 problemlos in die Zwischenräume zwischen den Halteschienen 502 und der Kontaktfläche 404 eingeführt werden kann. In einem nächsten Schritt wird der Träger 206 soweit verlagert, bis die Kontaktfläche 404 und die Gegenkontaktfläche 210 des Trägers 206 sich vollständig überdecken, so dass die Kontaktfläche 404 vollflächig in Kontakt mit der Gegenkontaktfläche 210 des Trägers 206 steht und der Wärmeübertrag von dem Träger 206 auf den Kühlkörper 400 maximiert ist. Somit ist eine einfache Montage ohne zusätzliche Befestigungsmittel möglich.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

Der Schutzbereich der vorliegenden Erfindung ist durch die Ansprüche gegeben und wird durch die in der Beschreibung erläuterten oder den Figuren gezeigten Merkmale nicht beschränkt.

### BEZUGSZEICHENLISTE

- 100: elektrische Baugruppe
- 102: Gehäuse
- 104: Rückseite
- 106: Rasteinrichtung
- 108: Hutschiene

- 200: Stromversorgungskomponente
- 202: Schaltnetzteil
- 204: elektrisches Bauteil
- 206: mehrschichtiger Träger
- 208: Oberseite
- 210: Gegenkontaktfläche

- 300: Metallplatte
- 302: Leiterbahnschicht
- 304: elektrische Isolationsschicht
- 308: Leiterbahn

- 400: Kühlkörper
- 402: Begrenzungen
- 404: Kontaktfläche
- 406: verformbarer Abschnitt
- 408: Gehäuse
- 410: Gehäuseabschnitt

- 500: Aufnahme
- 502: Halteschiene
- 504: Flächenanteil
- 506: Randabschnitt

- 600: Wärmeabstrahlfläche
- 602: Erhebungen
- 604: Phase

- 606: Abschnitt

## Patentansprüche

1. Elektrische Baugruppe (100) zur Montage auf einer Hutschiene (108), mit:
- einer elektrischen Stromversorgungskomponente (200);
- einem mehrschichtigen Träger (206), umfassend eine Metallplatte (300), eine Leiterbahnschicht (302) zur elektrischen Kontaktierung der elektrischen Stromversorgungskomponente (200) und eine elektrische Isolationsschicht (304), welche zwischen der Metallplatte (300) und der Leiterbahnschicht (302) angeordnet ist, wobei die elektrische Isolationsschicht (304) eine thermisch leitende Dielektrikumsschicht ist; wobei
- die elektrische Stromversorgungskomponente (200) mit der Metallplatte (300) wärmeleitend verbunden ist, um Wärmeenergie von der elektrischen Stromversorgungskomponente (200) abzuführen; und mit
- einem Kühlkörper (400) um Wärmeenergie von der elektrischen Stromversorgungskomponente (200) abzuführen, der einstückig und materialeinheitlich aus faserverstärktem Kunststoff gefertigt ist, wobei der Kühlkörper (400) als Gehäuseabschnitt (410) eines Gehäuses (408) zur Hausung der Stromversorgungskomponente (200) ausgebildet ist, wobei der Gehäuseabschnitt (410) des Gehäuses (408) mit der Metallplatte (300) wärmeleitend verbunden ist.

2. Elektrische Baugruppe (100) nach Anspruch 1, wobei die Metallplatte (300) oder die Leiterbahnschicht (302) aus zumindest einem der folgenden Materialien gebildet ist: Aluminium, Kupfer, Aluminium enthaltende Legierung, Kupfer enthaltende Legierung.

3. Elektrische Baugruppe (100) nach einem der vorstehenden Ansprüche, wobei die Leiterbahnschicht (302) durch elektrische Leiterbahnen (308) gebildet ist.

4. Elektrische Baugruppe (100) nach einem der vorstehenden Ansprüche, wobei die Metallplatte (300) als Schirm für ein von der elektrischen Stromversorgungskomponente (200) abstrahlbares elektromagnetisches Wechselfeld vorgesehen ist.

5. Elektrische Baugruppe (100) nach einem der vorstehenden Ansprüche, wobei die Metallplatte (300) zur Abschirmung elektromagnetischer Wechselfelder mit einer Frequenz von bis zu 30 MHz ausgebildet ist.

6. Elektrische Baugruppe (100) nach einem der vorstehenden Ansprüche, wobei die Metallplatte (300) vollflächig ausgebildet ist.

7. Elektrische Baugruppe (100) nach einem der vorstehenden Ansprüche, wobei die Metallplatte (300) mit einem Referenzpotential, insbesondere mit einem Massepotential, verbindbar ist.

8. Elektrische Baugruppe (100) nach einem der vorstehenden Ansprüche, wobei die elektrische Stromversorgungskomponente (200) ein Schaltnetzteil (202) ist.

## Claims

1. Electric assembly (100) for assembly on a top-hat rail (108), comprising:
- an electric power supply component (200);
- a multilayer carrier (206), comprising a metal plate (300), a conductor path layer (302) for electrically contacting the electric power supply component (200) and an electric insulation layer (304) which is arranged between the metal plate (300) and the conductor path layer (302), wherein the electric insulation layer (304) is a thermally conductive dielectric layer; wherein
- the electric power supply component (200) is connected to the metal plate (300) in a thermally conductive manner in order to dissipate thermal energy from the electric power supply component (200); and comprising
- a cooling element (400) in order to dissipate thermal energy from the electric power supply component (200), which is formed integrally and in a material uniform manner from fiber-reinforced plastic, wherein the cooling element (400) is configured as a housing section (410) of a housing (408) for housing the power supply component (200), wherein the housing section (410) of the housing (408) is connected to the metal plate (300) in a thermally conductive manner.

2. Electric assembly (100) according to claim 1, wherein the metal plate (300) or the conductor path layer (302) is formed from at least one of the following materials: aluminum, copper, aluminum-containing alloy, copper-containing alloy.

3. Electric assembly (100) according to one of the preceding claims, wherein the conductor path layer (302) is formed by electric conductor paths (308).

4. Electric assembly (100) according to one of the preceding claims, wherein the metal plate (300) is provided as a shield for an alternating electromagnetic field radiatable from the electric power supply component (200).

5. Electric assembly (100) according to one of the preceding claims, wherein the metal plate (300) is configured to shield alternating electromagnetic fields with a frequency of up to 30 MHz.

6. Electric assembly (100) according to one of the preceding claims, wherein the metal plate (300) is formed in a full-surfaced manner.

7. Electric assembly (100) according to one of the preceding claims, wherein the metal plate (300) is connectable to a reference potential, in particular to a mass potential.

8. Electric assembly (100) according to one of the preceding claims, wherein the electric power supply component (200) is a switching power supply (202).

## Revendications

1. Sous-ensemble électrique (100) destiné à être monté sur un profilé chapeau (108), comprenant :
- un composant d'alimentation en courant électrique (200) ;
- un support multicouche (206), comprenant une plaque métallique (300), une couche de pistes conductrices (302) destinée à la mise en contact électrique du composant d'alimentation en courant électrique (200) et une couche d'isolation électrique (304) qui est disposée entre la plaque métallique (300) et la couche de pistes conductrices (302), la couche d'isolation électrique (304) étant une couche diélectrique thermoconductrice ; dans lequel
- le composant d'alimentation en courant électrique (200) est relié de manière thermoconductrice à la plaque métallique (300) afin d'évacuer de l'énergie thermique du composant d'alimentation en courant électrique (200) ; et comprenant
- un dissipateur thermique (400) pour évacuer de l'énergie thermique du composant d'alimentation en courant électrique (200), et qui est fabriqué d'un seul tenant et d'un seul matériau en matière plastique renforcée par des fibres, le dissipateur thermique (400) étant réalisé sous la forme d'une partie de boîtier (410) d'un boîtier (408) destiné à loger le composant d'alimentation en courant (200), la partie de boîtier (410) du boîtier (408) étant reliée de manière thermoconductrice à la plaque métallique (300).

2. Sous-ensemble électrique (100) selon la revendication 1, dans lequel la plaque métallique (300) ou la couche de pistes conductrices (302) est réalisée à partir d'au moins l'un des matériaux suivants : aluminium, cuivre, alliage contenant de l'aluminium, alliage contenant du cuivre.

3. Sous-ensemble électrique (100) selon l'une quelconque des revendications précédentes, dans lequel la couche de pistes conductrices (302) est formée par des pistes conductrices électriques (308).

4. Sous-ensemble électrique (100) selon l'une quelconque des revendications précédentes, dans lequel la plaque métallique (300) est prévue comme blindage pour un champ alternatif électromagnétique pouvant être émis par le composant d'alimentation en courant électrique (200).

5. Sous-ensemble électrique (100) selon l'une quelconque des revendications précédentes, dans lequel la plaque métallique (300) est réalisée pour blinder des champs alternatifs électromagnétiques ayant une fréquence allant jusqu'à 30 MHz.

6. Sous-ensemble électrique (100) selon l'une quelconque des revendications précédentes, dans lequel la plaque métallique (300) est réalisée sur toute la surface.

7. Sous-ensemble électrique (100) selon l'une quelconque des revendications précédentes, dans lequel la plaque métallique (300) peut être reliée à un potentiel de référence, en particulier à un potentiel de masse.

8. Sous-ensemble électrique (100) selon l'une quelconque des revendications précédentes, dans lequel le composant d'alimentation en courant électrique (200) est une alimentation à découpage (202).
